# EUROPÄISCHE PATENTSCHRIFT

(11) **EP 1 861 651 B1**
(45) Veröffentlichungstag und Bekanntmachung des Hinweises auf die Patenterteilung: **10.06.2009**
(21) Anmeldenummer: 06742515.7
(22) Anmeldetag: 08.03.2006
(51) Int. Cl.: F21K 7/00, H05K 1/05

(54) **FLÄCHIGE BELEUCHTUNGSEINRICHTUNG**
FLAT ILLUMINATING DEVICE
DISPOSITIF D'ÉCLAIRAGE PLAT

(30) Priorität: 15.03.2005 DE 102005011857
(43) Veröffentlichungstag der Anmeldung: 05.12.2007
(73) Patentinhaber: Alcan Technology & Management Ltd., 8212 Neuhausen am Rheinfall (CH)
(72) Erfinder: LAYER, Hans, 89075 Ulm (DE); WERNER, Martin, 78224 Singen (DE)
(86) Internationale Anmeldenummer: PCT/EP2006/002102
(87) Internationale Veröffentlichungsnummer: WO 2006/097225

(56) Entgegenhaltungen:
- EP-A- 1 020 909
- EP-A- 1 059 667
- DE-A1- 10 026 460
- US-A1- 2003 193 055
- PATENT ABSTRACTS OF JAPAN Bd. 1997, Nr. 03, 31. März 1997 (1997-03-31) -& JP 08 298345 A (SHICHIZUN DENSHI:KK), 12. November 1996 (1996-11-12)

## Beschreibung

Die Erfindung bezieht sich auf eine flächige Beleuchtungseinrichtung und auf ein Verfahren zur Herstellung derselben.

Es sind optoelektronische Module bekannt, bei denen auf einem Substrat mehrere Beleuchtungselemente angeordnet sind. Dabei besteht ein Problem darin, dass die Beleuchtungselemente aufgrund der Erwärmung nur mit einem relativ geringen Strom von etwa 10 bis 50 mA betrieben werden können. Die Menge des von den Beleuchtungselementen abgestrahlten Lichtes ist daher gering.

Aus der DE 100 33 502 A1 geht ein optoelektronisches Modul hervor, bei dem auf einem gut wärmeleitenden Substrat lichtemittierende Halbleiterbauelemente befestigt sind. Die Unterseite des Substrates ist auf einem metallischen Trägerkörper befestigt, der eine hohe Wärmekapazität und eine gute Wärmeleitfähigkeit besitzt. Die Bauelementbefestigung zwischen den Halbleiterbauelementen und dem Substrat ist ebenso wie die Substratbefestigung zwischen dem Substrat und dem Trägerkörper gut wärmeleitend ausgeführt. Das Substrat kann aus Silizium bestehen, das ein leichter und relativ preiswert verfügbarer Werkstoff ist und eine hervorragende Wärmeleitung aufweist. Das gesamte Modul ist durch einen Glaskörper abgedeckt, der eine die Substratoberfläche freiliegende Vertiefung aufweist, in der die Halbleiterbauelemente angeordnet sind.

Die US 2003/0193055 offenbart ein flächiges Trägersubstrat für Leuchtdioden, dessen Kernebene durch ein Metallsubstrat gebildet ist und auf dessen Oberfläche auf einer isolierenden Schicht die Leuchtmittel angebracht sind.

Ferner ist aus der EP 1 788 640 ein Trägersubstrat als Folie bekannt, auf dem LED's auf Leiterbahnen aufliegen.

Die Aufgabe der vorliegenden Erfindung besteht darin, eine Beleuchtungseinrichtung, die einen relativ hohen Wirkungsgrad und eine lange Lebensdauer besitzt und zudem relativ einfach aufgebaut ist, und ein Verfahren zur Herstellung derselben anzugeben.

Diese Aufgabe wird durch eine Beleuchtungseinrichtung mit den Merkmalen des Patentanspruches 1 sowie durch ein Verfahren mit den Merkmalen des Patentanspruches 31 gelöst.

Der wesentliche Vorteil der vorliegenden Beleuchtungseinrichtung, die vorzugsweise die Form einer Lichttapete oder eines Lichtpaneels besitzt, besteht darin, dass sie besonders einfach aufgebaut ist und wie eine großflächige Tapete oder wie einzelne Paneele gehandhabt und installiert werden kann. Das Verfahren zur Herstellung der erfindungsgemäßen Beleuchtungseinrichtung ist ebenfalls relativ einfach und kostengünstig ausführbar. Dies ist auf die spezielle Struktur der erfindungsgemäßen Beleuchtungseinrichtung zurückzuführen.

Da die einzelnen Beleuchtungselemente bzw. lichtemittierenden Dioden, so angeordnet sind, dass eine hervorragende Wärmeübertragung bzw. Ableitung in die als Träger dienende metallische Trägerfolie erfolgt, können die einzelnen Beleuchtungselemente je nach ihrer Anzahl mit einer Betriebsspannung von z. B. 20 V betrieben werden. Damit liegt die Betriebsspannung im Bereich von Kleinspannungen gemäß den VDE-Normen. Der Isolationsaufwand wird daher vorteilhafter Weise gering gehalten.

Besonders einfach und vorteilhaft werden die als Trägerfolie dienenden, hart gewalzten Aluminiumfolien flächig mit einer isolierenden Schicht, insbesondere mit einer Decklackschicht, als Isolator versehen und im Tiefdruckverfahren mehrschichtig mit einer Leitfarbe, vorzugsweise einer Silberleitfarbe, zur Herstellung der verschiedenen Leiterbahnen und der Anschlusskontaktflächen, sowie mit einer weiteren Leitfarbe, vorzugsweise einer Grafitleitfarbe, zur Herstellung der Vorwiderstände bedruckt. Auch dieses Verfahren ist besonders einfach ausführbar und kostengünstig. Dabei werden in einem Tiefdruckdurchgang sowohl die der Stromzu- und Stromabfuhr und der Stromverteilung in der Fläche der Beleuchtungseinrichtung dienenden Leiterbahnen als auch die Anschlussflächen für die lichtemittierenden Bauelemente in der Silberleitfarbe aufgedruckt. Da vorteilhafter Weise auch die vorzugsweise aus Grafitleitfarbe bestehenden Widerstandsflächen der Vorwiderstände, die durch vorzugsweise aus Silber bestehende Ein- und Ausleitungen gespeist werden, durch das Tiefdruckverfahren aufgedruckt werden, liegt die notwendige geringe Toleranz der Vorwiderstände wegen der hohen Gleichmäßigkeit des Tiefdruckverfahrens vorteilhafter Weise weit unter 10 %. Die erforderliche Verlustleistung der Vorwiderstände wird durch die relativ großflächige Ausgestaltung der aufgedruckten Widerstandsflächen erreicht. Die lichtemittierenden Beleuchtungselemente werden vorzugsweise mit einem silberhaltigen Leitkleber an den entsprechenden Anschlusskontaktflächen verklebt, oder an diesen verlötet. Der genannte silberhaltige Leitkleber besitzt einen sehr kleinen Wärmeleitkoeffizienten, sodass eine gute Wärmeableitung aus den lichtemittierenden Beleuchtungselementen zur metallischen Trägerfolie erfolgt.

Bei einer bevorzugten Ausgestaltung der Erfindung als Lichttapete werden jeweils parallele Zweige mit vier oder mehr in Reihe geschalteten Reihenschaltungen aus jeweils einem lichtemittierenden Beleuchtungselement und einem Vorwiderstand zur Kompensation der unterschiedlichen Durchlasskennlinien der Beleuchtungselemente zwischen den Stromzu- und Stromableitungen angeordnet.

Die einzelnen lichtemittierenden Beleuchtungselemente werden nach ihrer Befestigung an den entsprechenden Anschlusskontaktflächen vorteilhafter Weise durch eine Stabilisierungsbeschichtung weiter fixiert und mechanisch stabilisiert.

Da die Oberfläche der metallischen Trägerfolie praktisch ohne Zusatzkosten mit Leiterbahnstrukturen im Tiefdruckverfahren belegt werden kann, werden bei einer bevorzugten Ausgestaltung der Erfindung vorteilhafter Weise zusätzliche Leiterbahnen zum Potentialausgleich parallel zu den Stromzu- und Stromableitungen mitgedruckt. Normalerweise fließt durch diese Potentialausgleichsleiterbahnen kein Strom, da alle lichtemittierenden Beleuchtungselemente, die zwischen einer Stromzuleitung und einer Stromableitung in Reihe geschaltet sind, auf gleichem Potential liegen. Fällt ein lichtemittierendes Beleuchtungselement aus, so fließt ein Querstrom, der die mit dem ausgefallenen lichtemittierenden Beleuchtungselement in Reihe geschalteten lichtemittierenden Beleuchtungselemente weiterhin mit Strom versorgt. Dadurch fällt vorteilhafter Weise nicht die gesamte Reihe der lichtemittierenden Beleuchtungselemente, sondern nur ein lichtemittierendes Beleuchtungselemente aus.

Ein wesentlicher Vorteil des erfindungsgemäßen Verfahrens besteht auch darin, dass wegen der Aufbringung der Leiterbahnen, der Stromzuleitungen, der Stromableitungen, der Anschlusskontaktflächen, ggf. der Potentialausgleichsleiterbahnen sowie der Vorwiderstandsflächen durch das Tiefdruckverfahren im Vergleich zu Verfahren mit geätzten Leiterplatten oder mit im Siebdruck hergestellten Leiterplatten wesentlich kostengünstiger gearbeitet werden kann, wobei durch die Verwendung einer Aluminiumfolie als metallische Trägerfolie gleichzeitig die nötige Wärmeverteilung erreicht wird, um die punktförmig erzeugte Wärme der lichtemittierenden Beleuchtungselemente in die Fläche an der Rückseite der Aluminiumfolie abzuleiten und zu verteilen.

Bei einer weiteren bevorzugten Ausgestaltung der Erfindung wird die flexible metallische Trägerfolie durch ein stabiles Verbundteil verstärkt, so dass selbsttragende Leuchtpaneele hergestellt werden können. Hierbei wird auf die metallische Trägerfolie ein vorzugsweise wabenförmig ausgestaltetes Verbundteil aus einem ebenfalls metallischen Material aufgeklebt, wobei die Gegenseite mit einem optisch transparenten oder einem eine diffuse Lichtverteilung bewirkenden opaken Kunststoff abgedeckt wird. Dadurch werden die lichtemittierenden Beleuchtungselemente, Leiterbahnen und Widerstände vorteilhafter Weise mechanisch und elektrisch geschützt und es entsteht ein stabiles Sandwichelement mit wärmeableitender Rückseite und lichtabgebender Vorderseite, das mit anderen entsprechend ausgebildeten Sandwichelementen zur Schaffung großer Leuchtflächen aneinander gereiht werden kann.

Im folgenden werden die Erfindung und deren Ausgestaltung im Zusammenhang mit den Figuren näher erläutert. Es zeigen:
Figur 1 einen Schnitt durch den Bereich eines lichtemittierenden Beleuchtungselementes der erfindungsgemäßen Beleuchtungseinrichtung;
Figur 2 eine Ansicht von oben auf eine mehrere lichtemittierende Beleuchtungselemente umfassende erfindungsgemäße Beleuchtungseinrichtung, die als Lichttapete ausgebildet ist, zur Erläuterung der Anordnung der Anschlusskontaktflächen sowie der Vorwiderstandsflächen und der Leiterbahnführung; und
Figur 3 eine als Lichtpaneel mit Sandwichkonstruktion ausgestaltete erfindungsgemäße Beleuchtungseinrichtung.

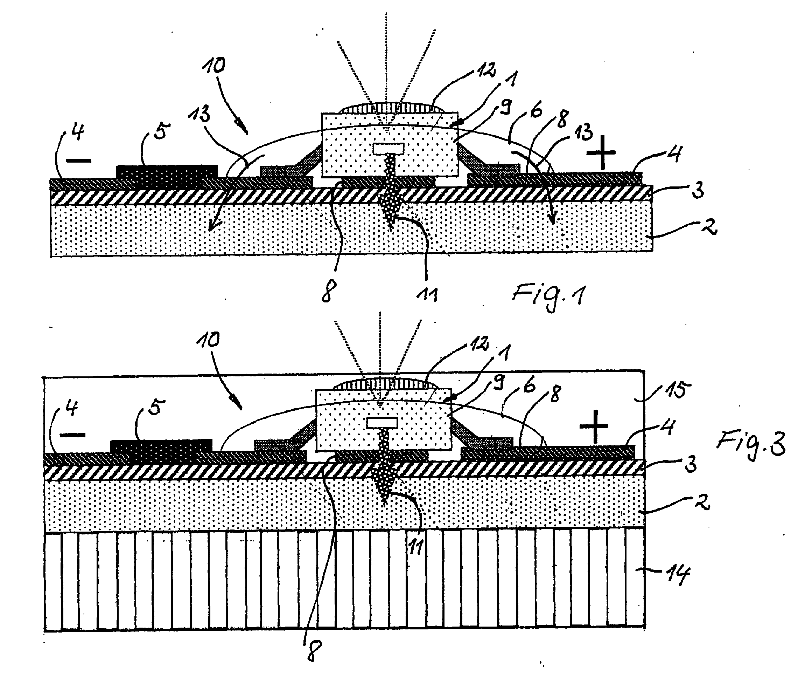

Gemäß Figur 1, die einen Schnitt durch den Bereich eines lichtemittierenden Beleuchtungselementes 1, vorzugsweise einer lichtemittierenden Diode, einer Beleuchtungseinrichtung 10 zeigt, besteht diese im wesentlichen aus einer metallischen Trägerfolie 2, die vorzugsweise die Form einer Aluminiumfolie besitzt, einer isolierenden Schicht 3, die vorzugsweise eine Lackschicht ist, Leiterbahnen 4, Anschlusskontaktflächen 8, Vorwiderstandsflächen 5, lichtemittierenden Dioden (LED) 1 und einer Stabilisierungsbeschichtung 6.

Bei der Ausführung des erfindungsgemäßen Verfahrens wird zunächst auf die Aluminiumfolie 2, die vorzugsweise hart gewalzt ist und eine Dicke von etwa 70 µm besitzt, flächig eine isolierende Lackschicht 3 aufgetragen, die vorzugsweise aus Polyurethan besteht und 10 µm dick ist. Es ist denkbar, dass die isolierende Lackschicht 3 zwei- oder mehrschichtig aufgetragen wird, um Isolationsfehler durch Löcher zu verhindern. Es ist weiterhin möglich, die Isolation durch eine auf die Aluminiumfolie aufkaschierte Papierbahn oder Kunststofffolie zu erreichen.

Auf die Oberfläche der isolierenden Lackschicht 3 werden im Tiefdruckverfahren verschiedene elektrisch leitende Bahnen bzw. Flächen, die vorzugsweise aus Leitfarben bestehen und zur Herstellung der Stromzu- und Stromableitungen 4', der Leiterbahnen 4 zur Stromverteilung in die Fläche der Beleuchtungseinrichtung 10, der Anschlusskontaktflächen 8 für die lichtemittierenden Dioden 1 sowie der Vorwiderstandsflächen 5 dienen, vorzugsweise mehrschichtig aufgedruckt. Die Stromzu- und Stromableitungen 4', die Leiterbahnen 4 sowie die Anschlusskontaktflächen 8 bestehen besonders bevorzugt aus einer in einem Tiefdruckverfahrensschritt aufgedruckten Silberleitfarbe. Die Vorwiderstandsflächen 5 bestehen vorzugsweise aus einer in einem getrennten Tiefdruckverfahrensschritt aufgedruckten Grafitleitfarbe

Die Vorwiderstandsflächen 5 werden in dem getrennten Tiefdruckverfahrensschritt die entsprechenden Leiterbahnen 4 überlappend erzeugt, so dass gute elektrische Verbindungen entstehen.

Anschließend werden die Anschlüsse 7 der lichtemittierenden Dioden 1 an den Anschlusskontaktflächen 8 der Leiterbahnen 4 befestigt. Zu diesem Zweck werden die Anschlüsse 7 bei einem Bestückvorgang in die richtige Lage in Bezug auf die Anschlusskontaktflächen 8 gebracht und mit der Hilfe eines Leitklebers an diesen befestigt bzw. verklebt, wobei eine gute elektrische Verbindung sowie eine Verbindung einer guten Wärmeleitfähigkeit bewirkt werden. Alternativ können die Anschlüsse 7 der Dioden 1 auch an den Anschlusskontaktflächen 8 verlötet werden.

In der richtigen Lage sitzt das wärmeleitende Körperteil 9 der Dioden 1, das vorzugsweise aus Kupfer besteht, auf einer darunter befindlichen Anschlusskontaktfläche 8 auf, sodass in der Richtung des Pfeils 11 eine gute Wärmeableitung vom Körperteil 9 über die Leiterbahn 4 und die Lackschicht 3 zur Aluminiumfolie 2 erfolgt.

Die Anschlusskontaktflächen 8 können auch direkt durch einen Teilbereich der Leiterbahnen 4 gebildet werden.

Zur Stabilisierung und mechanischen Fixierung der Dioden 1 wird zweckmäßigerweise eine Stabilisierungsbeschichtung 6 auf den Befestigungsbereich der Dioden 1 aufgebracht, wobei dafür Sorge getragen wird, dass die Dioden 1 jeweils nur soweit in das Material der Beschichtung 6 eingebettet werden, dass ihre lichtabgebende Vorderseite 12 frei liegt. Die Stabilisierungsbeschichtung 6 überdeckt gleichzeitig jeweils auch die Kontakte zwischen den Anschlüssen 7 der Dioden 1 und den entsprechenden Anschlusskontaktflächen 8. Die Aufbringung der stabilisierenden Beschichtung 6 ist besonders vorteilhaft, weil durch sie ein fester Verbund zwischen den Dioden 1 und der Aluminiumfolie 2 hergestellt wird, der gegenüber der an sich flexiblen Aluminiumfolie 2 starr ist. Dadurch werden Biegeradien, die bei der Handhabung der Beleuchtungseinrichtung 10 durch Verbiegungen entstehen, nicht direkt in die Kontaktstellen, sondern, wie dies durch die Pfeile 13 dargestellt ist, in die Aluminiumfolie 2 eingeleitet. Die Kontaktstellen werden dadurch wesentlich entlastet.

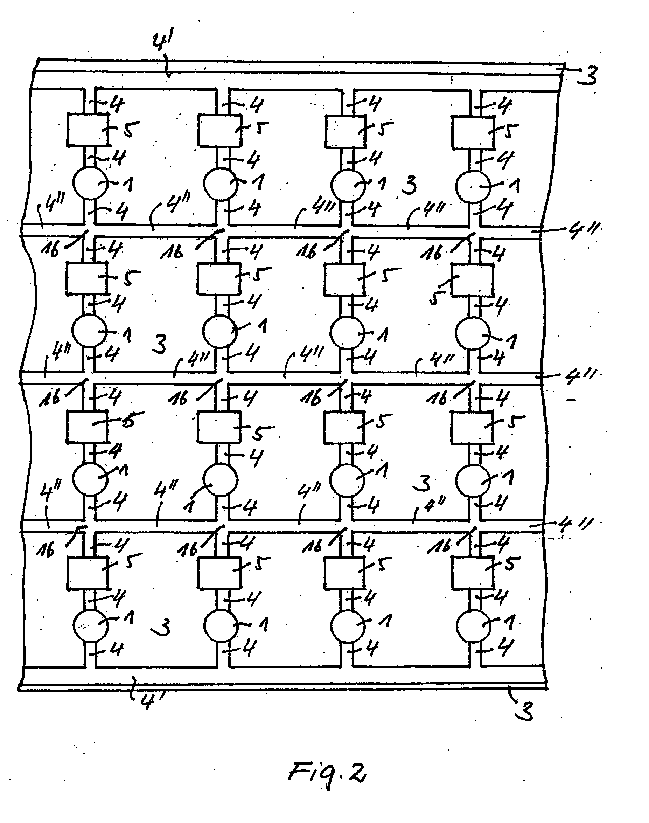

Gemäß der Figur 2 verlaufen zwischen den parallelen Stromzu- und Stromableitungen 4' nebeneinander angeordnet, parallele Zweige, die jeweils mehrere (z.B. vier) Reihenschaltungen aus jeweils einer Vorwiderstandsfläche 5 und einer Diode 1 in Reihe umfassen. Die Vorwiderstandsfläche 5 und die Diode 1 der Reihenschaltungen sind jeweils über eine Leiterbahn 4 miteinander verbunden. Die Reihenschaltungen eines Zweiges sind untereinander bzw. mit der Stromzu- und Stromableitung 4' ebenfalls über Leiterbahnen 4 verbunden.

Die in Richtung der Stromzu- und Stromableitungen 4' nebeneinander angeordneten Punkte 16 der Leiterbahnen 4 der Zweige, welche jeweils zwischen zwei sich entsprechenden Reihenschaltungen der Zweige liegen, können aus den eingangs erwähnten Gründen bevorzugt durch Potentialausgleichsleitungen 4'' miteinander verbunden sein, die parallel zu den Stromzu- und Stromableitungen 4' verlaufen.

Zur Herstellung einer stabilen Beleuchtungseinrichtung 10', die als Leuchtpaneel gehandhabt werden kann, wird gemäß Figur 3 an der den Dioden 1 abgewandten Seite der Aluminiumfolie 2 ein vorzugsweise wabenförmig ausgestaltetes metallisches Verbundteil 14 befestigt, vorzugsweise verklebt, das zweckmäßigerweise aus Aluminium besteht. Auf der Seite der Dioden 1 kann dann eine optisch transparente oder zur diffusen Lichtverteilung opake Abdeckung 15, die vorzugsweise aus einem Kunststoffmaterial besteht, aufgebracht werden. Auf diese Weise entsteht eine Beleuchtungseinrichtung 10' in Sandwichkonstruktion mit einer wärmeableitenden Aluminiumrückseite und einer lichtabgebenden Vorderseite, wobei die Dioden 1, die Leiterbahnen 4, die Anschlusskontaktflächen 8, die Anschlüsse 7 der Dioden 1 und die Vorwiderstandsflächen 5 mechanisch und elektrisch gut geschützt sind.

### Bezugszeichen

- 1: Beleuchtungselement
- 2: Trägerfolie
- 3: isolierende Schicht
- 4: Leiterbahn
- 4': Stromzu- und Stromableitung
- 4'': Potentialausgleichsleitung
- 5: Vorwiderstandsfläche
- 6: Stabilisierungsbeschichtung
- 7: Anschluss
- 8: Anschlusskontaktflächen
- 9: Körperteil
- 10: Beleuchtungseinrichtung
- 10': Beleuchtungseinrichtung
- 11: Pfeil
- 12: Vorderseite
- 13: Pfeil
- 14: Verbundteil
- 15: Abdeckung
- 16: Punkt

## Patentansprüche

1. Flächige Beleuchtungseinrichtung mit auf einem Träger angeordneten lichtemittierenden Beleuchtungselementen, die zur Stromversorgung mit Stromzu- und Stromableitungen verbunden sind, wobei der Träger die Form einer metallischen Folie (2) aufweist, **dadurch gekennzeichnet, dass** die metallische Folie mit einer isolierenden Schicht (3) bedeckt ist, auf der jeweils zwischen den Stromzu- und Stromableitungen (4') Reihenschaltungen aus jeweils einem Beleuchtungselement (1) und einer Vorwiderstandsfläche (5) angeordnet sind, und dass jeweils ein Beleuchtungselement (1) und eine Vorwiderstandsfläche (5) einer Reihenschaltung sowie die Reihenschaltungen und die Stromzu- und Stromableitungen (4') über Leiterbahnen (4) miteinander verbunden sind.

2. Beleuchtungseinrichtung nach Anspruch 1, **dadurch gekennzeichnet, dass** zwischen den Stromzu- und Stromableitungen (4') nebeneinander mehrere Reihenschaltungen angeordnet sind.

3. Beleuchtungseinrichtung nach Anspruch 1 , **dadurch gekennzeichnet, dass** zwischen den Stromzu- und Stromableitungen (4') nebeneinander mehrere Zweige angeordnet sind, die jeweils hintereinander mehrere Reihenschaltungen aus jeweils einem Beleuchtungselement (1) und einer Vorwiderstandsfläche (5) umfassen.

4. Beleuchtungseinrichtung nach Anspruch 3, **dadurch gekennzeichnet, dass** Potentialausgleichsleitungen (4'') vorgesehen sind, die jeweils die nebeneinander angeordneten Punkte (16) der Leiterbahnen (4) der Zweige miteinander verbinden, welche zwischen Reihenschaltungen aus jeweils einem Beleuchtungselement (1) und einer Vorwiderstandsfläche (5) angeordnet sind.

5. Beleuchtungseinrichtung nach einem der Ansprüche 1 bis 4, **dadurch gekennzeichnet, dass** die metallische Folie (2) eine Aluminiumfolie ist.

6. Beleuchtungseinrichtung nach Anspruch 5, **dadurch gekennzeichnet, dass** die Aluminiumfolie eine Dicke von etwa 70 µm besitzt.

7. Beleuchtungseinrichtung nach einem der Ansprüche 1 bis 6, **dadurch gekennzeichnet, dass** die isolierende Schicht (3) eine flächig aufgetragene Lackschicht ist.

8. Beleuchtungseinrichtung nach Anspruch 7, **dadurch gekennzeichnet, dass** die Lackschicht (3) aus Polyurethan besteht.

9. Beleuchtungseinrichtung nach Anspruch 7 oder 8, **dadurch gekennzeichnet, dass** die Lackschicht etwa 10 µm dick ist.

10. Beleuchtungseinrichtung nach einem der Ansprüche 7 bis 9, **dadurch gekennzeichnet, dass** die Lackschicht zur Vermeidung von Isolationsfehlern durch Löcher zwei- oder mehrschichtig übereinander aufgetragen ist.

11. Beleuchtungseinrichtung nach einem der Ansprüche 1 bis 6, **dadurch gekennzeichnet, dass** die isolierende Schicht (3) durch eine auf die metallische Folie (2) aufkaschierte Kunststofffolie gebildet ist.

12. Beleuchtungseinrichtung nach einem der Ansprüche 1 bis 6, **dadurch gekennzeichnet, dass** die isolierende Schicht (2) durch eine auf die metallische Folie (2) aufkaschierte Papierbahn gebildet ist.

13. Beleuchtungseinrichtung nach einem der Ansprüche 1 bis 12, **dadurch gekennzeichnet, dass** die Leiterbahnen (4), die Stromzu- und Stromableitungen (4') und ggf. die Potentialausgleichsleitungen (4'') auf die Oberfläche der isolierenden Schicht (3) in einem Tiefdruckverfahren aufgedruckt sind.

14. Beleuchtungseinrichtung nach einem der Ansprüche 1 bis 13, **dadurch gekennzeichnet, dass** die Leiterbahnen, die Stromzu- und Stromableitungen (4') aus einer Leitfarbe bestehen.

15. Beleuchtungseinrichtung nach Anspruch 14, **dadurch gekennzeichnet, dass** die Leitfarbe eine Silberleitfarbe ist.

16. Beleuchtungseinrichtung nach einem der Ansprüche 1 bis 15, **dadurch gekennzeichnet, dass** die Vorwiderstandsflächen (5) auf die Oberfläche der isolierenden Schicht (3) im Tiefdruckverfahren aufgedruckt sind.

17. Beleuchtungseinrichtung nach Anspruch 16, **dadurch gekennzeichnet, dass** die Vorwiderstandsflächen (5) und die Leiterbahnen (4) sich überlappend aufgedruckt sind.

18. Beleuchtungseinrichtung nach Anspruch 16 oder 17, **dadurch gekennzeichnet, dass** die Vorwiderstandsflächen aus einer weiteren Leitfarbe bestehen.

19. Beleuchtungseinrichtung nach Anspruch 18, **dadurch gekennzeichnet, dass** die weitere Leitfarbe eine Grafitleitfarbe ist.

20. Beleuchtungseinrichtung nach einem der Ansprüche 1 bis 19, **dadurch gekennzeichnet, dass** die Anschlüsse (7) der Beleuchtungselemente (1) jeweils mit an Leiterbahnen (4) angeordneten Anschlusskontaktflächen (7) mit einem Leitkleber verklebt oder verlötet sind.

21. Beleuchtungseinrichtung nach Anspruch 20, **dadurch gekennzeichnet, dass** die Anschlusskontaktflächen (7) zusammen mit den entsprechenden Leiterbahnen (4) in einem Tiefdruckverfahren aufgedruckt sind.

22. Beleuchtungseinrichtung nach einem der Ansprüche 1 bis 21, **dadurch gekennzeichnet, dass** die Beleuchtungselemente (1) lichtemittierende Dioden sind.

23. Beleuchtungseinrichtung nach einem der Ansprüche 1 bis 22, **dadurch gekennzeichnet, dass** das Körperteil (9) eines fixierten Beleuchtungselementes (1) auf einer darunter befindlichen Kontaktanschlussfläche (8) aufsitzt, so dass eine gute Wärmeableitung vom Körperteil (9) zur metallischen Folie (2) erfolgt.

24. Beleuchtungseinrichtung nach einem der Ansprüche 1 bis 23, **dadurch gekennzeichnet, dass** auf den Beleuchtungselementen (1) zur Stabilisierung und zur mechanischen Fixierung derselben eine Stabilisierungsbeschichtung (6) angeordnet ist, die auch die Bereiche der Anschlüsse (7) der Beleuchtungselemente (1) und der Anschlusskontaktflächen (8) überdeckt, jedoch die lichtabgebende Vorderseite der Beleuchtungselemente (1) frei lässt.

25. Beleuchtungseinrichtung nach einem der Ansprüche 1 bis 24, **dadurch gekennzeichnet, dass** an der den Beleuchtungselementen (1) abgewandten Seite der metallischen Folie (2) ein stabilisierendes metallisches Verbundteil (14) befestigt ist.

26. Beleuchtungseinrichtung nach Anspruch 25, **dadurch gekennzeichnet, dass** das Verbundteil (14) wabenförmig ausgestaltet ist.

27. Beleuchtungseinrichtung nach Anspruch 25 oder 26, **dadurch gekennzeichnet, dass** das Verbundteil aus Aluminium besteht.

28. Beleuchtungseinrichtung nach einem der Ansprüche 25 bis 27, **dadurch gekennzeichnet, dass** an der dem Verbundteil (14) gegenüberliegenden Seite der Beleuchtungseinrichtung eine Abdeckung (15) befestigt ist.

29. Beleuchtungseinrichtung nach Anspruch 28, **dadurch gekennzeichnet, dass** die Abdeckung (15) aus einem transparenten oder opaken Material besteht.

30. Beleuchtungseinrichtung nach Anspruch 29, **dadurch gekennzeichnet, dass** die Abdeckung (15) aus einem Kunststoffmaterial besteht.

31. Verfahren zur Herstellung einer Beleuchtungseinrichtung nach einem der Ansprüche 1 bis 30, **dadurch gekennzeichnet, dass** auf der metallischen Folie (2) die isolierende Schicht aufgetragen wird und dass auf die isolierenden Schicht (3) die Leiterbahnen (4), die Stromzu- und Ableitungen (4'), die Anschlusskontaktflächen (8) und ggf. die Potentialausgleichsleitungen (4'') im Tiefdruckverfahren aufgedruckt werden.

32. Verfahren nach Anspruch 31, **dadurch gekennzeichnet, dass** ) die Leiterbahnen (4), die Stromzu- und Ableitungen (4'), die Anschlusskontaktflächen (8) und ggf. die Potentialausgleichsleitungen (4'') ein- oder mehrschichtig aufgedruckt werden.

33. Verfahren nach Anspruch 32, **dadurch gekennzeichnet, dass** als Material für die Leiterbahnen (4), die Stromzu- und Stromableitungen (4'), die Anschlusskontaktflächen (8) und ggf. die Potentialausgleichsleitungen (4'') eine Leitfarbe, vorzugsweise eine Silberleitfarbe, aufgedruckt wird.

34. Verfahren nach einem der Anspruch 31 bis 33, **dadurch gekennzeichnet, dass** die Vorwiderstandsflächen (5) im Tiefdruckverfahren getrennt ein- oder mehrschichtig aufgedruckt werden.

35. Verfahren nach Anspruch 34, **dadurch gekennzeichnet, dass** die Vorwiderstandsflächen (5) und die Leiterbahnen (4) sich überlappend aufgedruckt werden.

36. Verfahren nach Anspruch 34 oder 35, **dadurch gekennzeichnet, dass** die Vorwiderstandsflächen (5) ein- oder mehrschichtig aufgedruckt werden.

37. Verfahren nach einem der Ansprüche 34 bis 36, **dadurch gekennzeichnet, dass** als Material für die Vorwiderstandsflächen (5) eine weitere Leitfarbe, vorzugsweise eine Grafitleitfarbe, verwendet wird.

38. Verfahren nach einem der Ansprüche 31 bis 37, **dadurch gekennzeichnet, dass** als isolierende Schicht (3) eine Lackschicht flächig aufgetragen wird, die vorzugsweise aus Polyurethan besteht und vorzugsweise etwa 10 µm dick ist.

39. Verfahren nach einem der Ansprüche 31 bis 38, **dadurch gekennzeichnet, dass** die isolierende Schicht (3) zur Vermeidung von Isolationsfehlern durch Löcher zwei- oder mehrschichtig übereinander aufgetragen wird.

40. Verfahren nach einem der Ansprüche 31 bis 37, **dadurch gekennzeichnet, dass** als isolierende Schicht (3) auf die metallische Folie (2) eine Kunststofffolie oder eine Papierbahn aufkaschiert wird.

41. Verfahren nach einem der Ansprüche 31 bis 40, **dadurch gekennzeichnet, dass** die Anschlüsse (7) der Beleuchtungselemente (1) jeweils mit Leiterbahnen (4) oder mit an Leiterbahnen (4) angeordneten Anschlusskontaktflächen (8) mit einem Leitkleber verklebt oder verlötet werden.

## Claims

1. Planar lighting device comprising light-emitting lighting elements arranged on a carrier, which are connected to current supply and current discharge lines to supply current, the carrier being in the form of a metal film (2), **characterised in that** the metal film is covered with an insulating layer (3), on which series connections, of a lighting element (1) and a series resistor surface (5) in each case, are in each case arranged between the current supply and current discharge lines (4'), and, in each case, a lighting element (1) and a series resistor surface (5) of a series connection as well as the series connections and the current supply and current discharge lines (4') are connected to one another by conductor paths (4).

2. Lighting device according to claim 1, **characterised in that** a plurality of series connections are arranged side by side between the current supply and current discharge lines (4').

3. Lighting device according to claim 1, **characterised in that** a plurality of branches, which in each case comprise behind one another a plurality of series connections, of a lighting element (1) and a series resistor surface (5) in each case, are arranged side by side between the current supply and current discharge lines (4').

4. Lighting device according to claim 3, **characterised in that** potential equalisation lines (4") are provided and in each case interconnect the points (16), arranged next to one another, of the conductor paths (4) of the branches, which are arranged between series connections, of a lighting element (1) and a series resistor surface (5) in each case.

5. Lighting device according to any one of claims 1 to 4, **characterised in that** the metal film (2) is an aluminium film.

6. Lighting device according to claim 5, **characterised in that** the aluminium film has a thickness of approximately 70 µm.

7. Lighting device according to any one of claims 1 to 6, **characterised in that** the insulating layer (3) is a coating layer applied in a planar manner.

8. Lighting device according to claim 7, **characterised in that** the coating layer (3) consists of polyurethane.

9. Lighting device according to either claim 7 or claim 8, **characterised in that** the coating layer is approximately 10 µm thick.

10. Lighting device according any one of claims 7 to 9, **characterised in that** the coating layer is applied in two or more layers on top of one another to avoid insulation defects due to holes.

11. Lighting device according to any one of claims 1 to 6, **characterised in that** the insulating layer (3) is formed by a plastics material film laminated onto the metal film (2).

12. Lighting device according to any one of claims 1 to 6, **characterised in that** the insulating layer (2) is formed by a paper web laminated onto the metal film (2).

13. Lighting device according to any one of claims 1 to 12, **characterised in that** the conductor paths (4), the current supply and current discharge lines (4') and optionally the potential equalisation lines (4") are printed onto the surface of the insulating layer (3) by a gravure printing method.

14. Lighting device according to any one of claims 1 to 13, **characterised in that** the conductor paths and the current supply and current discharge lines (4') consist of a conductive dye.

15. Lighting device according to claim 14, **characterised in that** the conductive dye is a silver conductive dye.

16. Lighting device according to any one of claims 1 to 15, **characterised in that** the series resistor surfaces (5) are printed onto the surface of the insulating layer (3) by the gravure printing method.

17. Lighting device according to claim 16, **characterised in that** the series resistor surfaces (5) and the conductor paths (4) are printed on in such a way as to overlap.

18. Lighting device according to either claim 16 or claim 17, **characterised in that** the series resistor surfaces consist of a further conductive dye.

19. Lighting device according to claim 18, **characterised in that** the further conductive dye is a graphite conductive dye.

20. The lighting according to any one of claims 1 to 19, **characterised in that** the connections (7) of the lighting elements (1) are in each case bonded with a conductive adhesive, or soldered to connection contact faces (7) which are arranged on conductor paths (4).

21. Lighting device according to claim 20, **characterised in that** the connection contact faces (7) are printed on together with the corresponding conductor paths (4) by a gravure printing method.

22. Lighting device according to any one of claims 1 to 21, **characterised in that** the lighting elements (1) are light-emitting diodes.

23. Lighting device according to any one of claims 1 to 22, **characterised in that** the body part (9) of a fixed lighting element (1) is seated on a contact connection face (8) located underneath, in such a way that there is good heat dissipation from the body part (9) into the metal film (2).

24. Lighting device according to any one of claims 1 to 23, **characterised in that** a stabilising coating (6) is arranged on the lighting elements (1) for the stabilisation and for the mechanical fixing thereof and also covers the regions of the connections (7) of the lighting elements (1) and of the connection contact faces (8), but leaves the light-emitting front of the lighting elements (1) uncovered.

25. Lighting device according to any one of claims 1 to 24**, characterised in that** a stabilising metal composite part (14) is fastened to the side of the metal film (2) remote from the lighting elements (1).

26. Lighting device according to claim 25, **characterised in that** the composite part (14) is honeycombed.

27. Lighting device according to either claim 25 or claim 26, **characterised in that** the composite part consists of aluminium.

28. Lighting device according to any one of claims 25 to 27, **characterised in that** a cover (15) is fastened to the side of the lighting device opposite the composite part (14).

29. Lighting device according to claim 28, **characterised in that** the cover (15) consists of a transparent or opaque material.

30. Lighting device according to claim 29, **characterised in that** the cover (15) consists of a plastics material.

31. Method for producing a lighting device according to any one of claims 1 to 30, **characterised in that** the insulating layer is applied to the metal film (2), and **in that** the conductor paths (4), the current supply and discharge lines (4'), the connection contact faces (8) and optionally the potential equalisation lines (4") are printed onto the insulating layer (3) by the gravure printing method.

32. Method according to claim 31, **characterised in that** the conductor paths (4), the current supply and discharge lines (4'), the connection contact faces (8) and optionally the potential equalisation lines (4") are printed on in one or more layers.

33. Method according to claim 32, **characterised in that** a conductive dye, preferably a silver conductive dye, is printed on as the material for the conductor paths (4), the current supply and current discharge lines (4'), the connection contact faces (8) and optionally the potential equalisation lines (4").

34. Method according to any one of claims 31 to 33, **characterised in that** the series resistor surfaces (5) are printed on separately in one or more layers by the gravure printing method.

35. Method according to claim 34, **characterised in that** the series resistor surfaces (5) and the conductor paths (4) are printed on in such a way as to overlap.

36. Method according to either claim 34 or claim 35, **characterised in that** the series resistor surfaces (5) are printed on in one or more layers.

37. Method according to any one of claims 34 to 36, **characterised in that** a further conductive dye, preferably a graphite conductive dye, is used as the material for the series resistor surfaces (5).

38. Method according to any one of claims 31 to 37, **characterised in that** a coating layer, which preferably consists of polyurethane and is preferably approximately 10 µm thick, is applied in a planar manner as the insulating layer (3).

39. Method according to any one of claims 31 to 38, **characterised in that** the insulating layer (3) is applied in two or more layers on top of one another to avoid insulation defects due to holes.

40. Method according to any one of claims 31 to 37, **characterised in that** a plastics material film or a paper web is laminated onto the metal film (2) as the insulating layer (3).

41. Method according to any one of claims 31 to 40, **characterised in that** the connections (7) of the lighting elements are in each case bonded with a conductive adhesive, or soldered, to conductor paths (4) or to connection contact faces (8) arranged on conductor paths (4).

## Revendications

1. Système d'éclairage surfacique, comprenant des éléments d'éclairage émetteurs de lumière agencés sur un support, qui seront reliés à des lignes d'arrivée et de départ de courant pour l'alimentation électrique, dans lequel le support présente la forme d'un film métallique (2), **caractérisé en ce que** le film métallique est recouvert d'une couche isolante (3) sur laquelle sont agencés des circuits série constitués chacun d'un élément d'éclairage (1) et d'une surface résistive (5), entre les lignes d'arrivée et de départ de courant respectives (4'), et **en ce qu'**un élément d'éclairage respectif (1) et une surface résistive (5) d'un circuit série, ainsi que les circuits série et les lignes d'arrivée et de départ de courant (4') sont relié(e)s les uns/unes aux autres via des pistes conductrices (4).

2. Système d'éclairage selon la revendication 1, **caractérisé en ce que** plusieurs circuits série sont agencés les uns à côté des autres entre les lignes d'arrivée et de départ de courant (4').

3. Système d'éclairage selon la revendication 1, **caractérisé en ce que** plusieurs ramifications sont agencées les unes à côté des autres entre les lignes d'arrivée et de départ de courant (4'), qui comprennent chacune plusieurs circuits série constitués chacun d'un élément d'éclairage (1) et d'une surface résistive (5), agencés respectivement les uns derrière les autres.

4. Système d'éclairage selon la revendication 3**, caractérisé en ce que** les lignes d'égalisation de potentiel (4') sont prévues, qui relient les uns aux autres respectivement les points (16), agencés les uns à côté des autres, des pistes conductrices (4) des ramifications qui sont agencées entre des circuits série constitués chacun d'un élément d'éclairage (1) et d'une surface résistive (5).

5. Système d'éclairage selon l'une des revendications 1 a 4, **caractérisé en ce que** le film métallique (2) est un film d'aluminium.

6. Système d'éclairage selon la revendication 5, **caractérisé en ce que** le film d'aluminium possède une épaisseur d'environ 70 µm.

7. Système d'éclairage selon l'une des revendications 1 à 6, **caractérisé en ce que** la couche isolante (2) est une couche de laque appliquée en surface.

8. Système d'éclairage selon la revendication 7, **caractérisé en ce que** la couche de laque (3) est en polyuréthane.

9. Système d'éclairage selon la revendication 7 ou 8, **caractérisé en ce que** la couche de laque est épaisse d'environ 10 µm.

10. Système d'éclairage selon l'une des revendications 7 à 9, **caractérisé en ce que** la couche de laque est appliquée sous forme de deux ou plusieurs couches les unes au-dessus des autres pour éviter des défauts d'isolation causés par des trous.

11. Système d'éclairage selon l'une des revendications 1 à 6, **caractérisé en ce que** la couche isolante (3) est formée par une couche de matière plastique stratifiée sur le film métallique (2).

12. Système d'éclairage selon l'une des revendications 1 à 6, **caractérisé en ce que** la couche isolante (2) est formée par une bande de papier stratifiée sur le film métallique (2).

13. Système d'éclairage selon l'une des revendications 1 à 12, **caractérisé en ce que** les pistes conductrices (4), les lignes d'arrivée et de départ de courant (4'), et le cas échéant les lignes d'égalisation de potentiel (4') sont imprimées sur la surface de la couche isolante (3) dans un procédé d'impression par héliogravure.

14. Système d'éclairage selon l'une des revendications 1 à 13, **caractérisé en ce que** les pistes conductrices et les lignes d'arrivée et de départ de courant (4') sont réalisées avec un pigment conducteur.

15. Système d'éclairage selon la revendication 14, **caractérisé en ce que** le pigment conducteur est un pigment conducteur à l'argent.

16. Système d'éclairage selon l'une des revendications 1 à 15, **caractérisé en ce que** surface résistive (5) sont imprimées sur la surface de la couche isolante (3) dans un procédé d'impression par héliogravure.

17. Système d'éclairage selon la revendication 16, **caractérisé en ce que** les surfaces résistives (5) et les pistes conductrices (4) sont imprimées de manière à se chevaucher.

18. Système d'éclairage selon la revendication 16 ou 17, **caractérisé en ce que** les surfaces résistives sont réalisées avec un autre pigment conducteur.

19. Système d'éclairage selon la revendication 18**, caractérisé en ce que** l'autre pigment conducteur est un pigment conducteur au graphite.

20. Système d'éclairage selon l'une des revendications 1 à 19, **caractérisé en ce que** les raccordements (7) des éléments d'éclairage (1) sont collés avec une colle conductrice ou brasés sur des surfaces de contact de raccordement (7) agencées respectivement sur les pistes de conductrices (4).

21. Système d'éclairage selon la revendication 20, **caractérisé en ce que** les surfaces de contact de raccordement (8) sont imprimées conjointement avec les pistes conductrices correspondantes (4) dans un procédé d'impression par héliogravure.

22. Système d'éclairage selon l'une des revendications 1 à 21, **caractérisé en ce que** les éléments d'éclairage (1) sont des diodes électroluminescentes.

23. Système d'éclairage selon l'une des revendications 1 à 22, **caractérisé en ce que** la partie formant corps (9) d'un élément d'éclairage fixé (1) repose sur une surface de contact de raccordement (8) située au-dessous, de sorte qu'il se produit une bonne dissipation thermique depuis la partie formant corps (9) vers le film métallique (2).

24. Système d'éclairage selon l'une des revendications 1 à 23, **caractérisé en ce que**, sur les éléments d'éclairage (1) et pour la stabilisation et la fixation mécanique de ceux-ci, est agencé un revêtement de stabilisation (6) qui recouvre également les zones des raccordements (7) des éléments d'éclairage (1) et des surfaces de contact de raccordement (8), mais qui laisse dégagée la face antérieure des éléments d'éclairage (1) qui émet la lumière.

25. Système d'éclairage selon l'une des revendications 1 à 24, **caractérisé en ce que,** du côté du film métallique (2) détourné des éléments d'éclairage (1), est fixée une pièce composite métallique (14) de stabilisation.

26. Système d'éclairage selon la revendication 25, **caractérisé en ce que** la pièce composite (14) est conçue à la manière de nid-d'abeilles.

27. Système d'éclairage selon la revendication 25 ou 26, **caractérisé en ce que** la pièce composite est en aluminium.

28. Système d'éclairage selon l'une des revendications 25 à 27, **caractérisé en ce que**, sur le côté du système d'éclairage opposé à la pièce composite (14), est fixé un recouvrement (15).

29. Système d'éclairage selon la revendication 28, **caractérisé en ce que** le recouvrement (15) est en un matériau transparent ou opaque.

30. Système d'éclairage selon la revendication 29, **caractérisé en ce que** le recouvrement (15) est en matière plastique.

31. Procédé pour la fabrication d'un système d'éclairage selon l'une des revendications 1 à 30, **caractérisé en ce que** l'on applique la couche isolante sur le film métallique (2), et on ce que l'on imprime dans un procédé d'impression par héliogravure les pistes conductrices (4), les lignes d'arrivée et de départ de courant (4'), les surfaces de contact de raceordement (8) et le cas échéant les lignes d'égalisation de potentiel (4") sur la couche isolante (3).

32. Procédé selon la revendication 31, **caractérisé en ce que** les pistes conductrices (4), les lignes d'arrivée et de départ de courant (4'), les surfaces de contact de raccordement (8), et le cas échéant les lignes d'égalisation de potentiel (4") sont imprimées sur une ou plusieurs couches.

33. Procédé selon la revendication 32, **caractérisé en ce que,** à titre de matériau pour les pistes conductrices (4), les lignes d'arrivée et de départ de courant (4'), les surfaces de contact de raccordement (8), et le cas échéant les lignes d'égalisation de potentiel (4"), on imprime un pigment conducteur, de préférence un pigment conducteur à l'argent.

34. Procédé selon l'une des revendications 31 à 33, **caractérisé en ce que** les surfaces résistives (5) sont imprimées séparément sur une ou plusieurs couches dans un procédé d'impression par héliogravure.

35. Procédé selon la revendication 34, **caractérisé en ce que** les surfaces résistives (5) et les pistes conductrices (4) sont imprimées de manière à se chevaucher.

36. Procédé selon la revendication 34 ou 35, **caractérisé en ce que** les surfaces résistives (5) sont imprimées sur une ou plusieurs couches.

37. Procédé selon l'une des revendications 34 à 36, **caractérisé en ce que** l'on utilise à titre de matériau pour les surfaces résistives (5) un autre pigment conducteur, de préférence un pigment conducteur au graphite.

38. Procédé selon l'une des revendications 31 à 37, **caractérisé en ce que** l'on applique en surface une couche de laque à titre de couche isolante (3), qui est de préférence en polyuréthane et a de préférence une épaisseur d'environ 10 µm.

39. Procédé selon l'une des revendications 31 à 38, **caractérisé en ce que** la couche isolante (3) est appliquée en deux ou plusieurs couches les unes sur les autres pour éviter des défauts d'isolation dus à des trous.

40. Procédé selon l'une des revendications 31 à 37, **caractérisé en ce que** l'on stratifie un film de matière plastique ou une bande de papier à titre de couche isolante (3) sur le film métallique (2).

41. Procédé selon l'une des revendications 31 à 40, **caractérisé en ce que** les raccordements (7) des éléments d'éclairage (1) sont collés avec une colle conductrice ou brasés sur les pistes conductrices (4) respectives ou sur des surfaces de contact de raccordement (8) agencées sur les pistes conductrices (4).
